# EUROPÄISCHE PATENTSCHRIFT

(11) **EP 1 290 732 B1**
(45) Veröffentlichungstag und Bekanntmachung des Hinweises auf die Patenterteilung: **29.09.2010**
(21) Anmeldenummer: 01936434.8
(22) Anmeldetag: 06.06.2001
(51) Int. Cl.: H01L 29/423, H01L 21/28

(54) **VERFAHREN ZUR HERSTELLUNG EINES FELDEFFEKTTRANSISTORS MIT EINEM FLOATING GATE**
METHOD FOR PRODUCING A FIELD EFFECT TRANSISTOR HAVING A FLOATING GATE
PROCEDE DE PRODUCTION D'UN TRANSISTOR A EFFET DE CHAMP A GRILLE FLOTTANTE

(30) Priorität: 14.06.2000 DE 10029287
(43) Veröffentlichungstag der Anmeldung: 12.03.2003
(73) Patentinhaber: Infineon Technologies AG, 85579 Neubiberg (DE)
(72) Erfinder: HOFMANN, Franz, 80995 München (DE); TEMPEL, Georg, B-1933 Sterrebeek (BE); STRENZ, Robert, 01099 Dresden (DE); WIESNER, Robert, 93049 Regensburg (DE)
(74) Vertreter: Wilhelm, Jürgen
(86) Internationale Anmeldenummer: PCT/EP2001/006407
(87) Internationale Veröffentlichungsnummer: WO 2001/097291

(56) Entgegenhaltungen:
- US-A- 5 847 427
- US-A- 5 866 930
- US-A- 5 888 870
- US-A- 5 936 883
- US-A- 6 001 713
- US-A- 6 069 041

## Beschreibung

Die Erfindung betrifft ein Verfahren gemäß dem Oberbegriff des Patentanspuchs 1 und des Patentanspruchs 4 zur Herstellung eines Feldeffekttransistors mit einem Floating Gate. Transistoren dieser Gattung enthalten auf der Oberfläche eines Halbleitersubstrates in einem sich von der Source zum Drain erstreckenden Bereich definierter Geometrie ein Steuergate über einer Isolierschicht. Das Floating Gate erstreckt sich in einem Teilbereich unter dem Steuergate und ist rundum isoliert. In solchen Feldeffekttransistoren kann elektrische Ladung über sehr lange Zeit in der Größenordnung von Jahren gespeichert werden; ihr bevorzugtes Einsatzgebiet sind daher programmierbare und umprogrammierbare Halbleiter-Festspeicher.

Bei einem herkömmlichen Herstellungsverfahren für Feldeffekttransistoren mit Floating Gate wird zunächst auf einem Teil der Substratoberfläche eine erste Schichtfolge aufgebaut, die zuunterst eine dünne dielektrische Schicht als Tunneldielektrikum für das Floating Gate (vorzugsweise eine Oxidschicht als sogenanntes "Tunneloxid"), darüber eine Schicht aus dem Material des Floating Gates und zuoberst eine Schicht mit guter dielektrischer Eigenschaft hat, um das Dielektrikum für die sogenannte Koppelkapazität zwischen Steuergate und Floating Gate zu bilden. Die letztgenannte Schicht, die im folgenden kurz als "Koppeldielektrikum" bezeichnet sei, enthält vorzugsweise eine Nitridschicht zwischen zwei dünnen Oxidschichten. Diese kombinierte Oxid-Nitrid-Oxid-Schicht, üblicherweise als "ONO"-Schicht bezeichnet, ist äußerst dünn, um eine hohe Koppelkapazität zu erhalten. Der ganze erste Schichtaufbau wird durch fotolithografische Ätztechnik so strukturiert, dass Seitenflanken entstehen, die Teile des endgültigen Umrisses des Floating Gates definieren. Anschließend werden zumindest derjenige übrige Teil der Substratoberfläche, über den sich das Steuergate erstrecken soll, und die erwähnten Seitenflanken des ersten Schichtaufbaus oxidiert, um auf dem besagten Teil der Substratoberfläche die Steuergate-Isolierschicht ("Hochvolt-Gateoxid") zu erzeugen und an den besagten Seitenflanken die Randisolation des Floating Gates zu bilden. Hierauf wird das Material des Steuergates aufgebracht, und nach Strukturierung des so gebildeten gesamten Schichtaufbaus auf den gewünschten Umriß des Steuergates erfolgt eine Post-Oxidierung der Oberflächen einschließlich der Flanken dieses Schichtaufbaus. Die selektive Dotierung des Substrats zur Bildung der Source- und Drainzonen erfolgt teils vor und teils nach der Post-Oxidierung.

Es wurde beobachtet, dass im Verlauf dieses Verfahrens das Material des Floating Gates unter den Randbereichen des Koppeldielektrikums zu einer Form aufoxidiert wird, die an die Gestalt eines Vogelschnabels erinnert. Diese Vogelschnäbel aus gebildetem Oxid vergrößern den Abstand zwischen dem verbleibenden Material des Floating Gates und dem Steuergate und biegen außerdem die Ränder des Koppeldielektrikums nach oben. Sie entstehen in besonders starkem Maß dort, wo die Seitenflanken des Floating Gates vor dem Aufbringen des Steuergate-Materials oxidiert werden. An diesen Stellen kommt es zu einer Verdickung des Koppeldielektrikums, da hierdurch der Abstand zwischen der Unterseite des anschließend aufgebrachten Steuergate-Materials und dem Material des Floating Gates noch zusätzlich vergrößert wird. Ähnliche Vogelschnäbel entstehen aber auch bei der späteren Post-Oxidierung, und zwar dort, wo nach der Strukturierung des Gesamt-Schichtaufbaus das Koppeldielektrikum und das Floating Gate an die Außenflanke treten. Wegen der vergleichsweise geringeren Dicke der Post-Oxidierung ist die Vogelschnabelbildung an dieser Stelle allerdings weniger ausgeprägt.

Durch den beschriebenen Vogelschnabel-Effekt wird die Koppelkapazität zwischen dem Steuergate und dem Floating Gate in unerwünschter Weise vermindert. Um diesen Nachteil auszugleichen, hat man bisher die horizontale Ausdehnung des Floating Gates und des darüberliegenden Koppeldielektrikums vergrößert und somit die "Zellfläche" größer bemessen als es eigentlich erwünscht wäre.

Verfahren gemäß dem Oberbegriff des Patentanspruchs 1 und des Patentanspruchs 4 zur Herstellung eines Feldeffekttransistors mit einem Floating Gate sind aus der US 6,069,041 bekannt. Diese Druckschrift beschreibt eine maskenlose Nitridierung des Floating Gates, um eine Seitenwandoxidation zu unterdrücken, so dass sogenannte Vogelschnäbel vermieden werden, wobei vorzugsweise eine Nitridierung aller Grenzflächen, insbesondere auch die der unter dem Floating Gate liegenden Tunneloxidschicht durchgeführt wird.

Aus der US 5,936,883 ist weiter ein Verfahren bekannt, bei dem eine seitliche Nitridierung der Floating Gate-Flanken vorgenommen, bevor das Kopplungsdielektrikum auf dem Floating Gate aufgebracht wird, wobei bei der Nitridierung die Gate-Flanken bis zur die darunter liegende Tunneloxidschicht vollständig freigelegt sind.

Ausgehend von diesem Stand der Technik ist es die Aufgabe der Erfindung, gegenüber der bekannten "Vogelschnabel"-Unterdrückungstechnik ein vereinfachtes Herstellungsverfahren bereitzustellen, mit denen sich unter Vermeidung von Vogelschnäbeln ein zuverlässig arbeitender Feldeffekttransistor erreichen läßt.

Diese Aufgabe wird erfindungsgemäß durch das im Patentanspruch 1 bzw. Patentanspruch 4 beschriebene Herstellungsverfahren gelöst. Vorteilhafte Ausgestaltungen der Erfindung sind in den Unteransprüchen gekennzeichnet.

Das Prinzip der Erfindung besteht demnach darin, vor der erstmaligen Oxidierung von Seitenflanken des Schichtaufbaus, der das Material des Floating Gates enthält, Stickstoff in dieses Material zu implantieren, wobei ein Nitridierung des unter dem Floating Gate liegenden Tunneloxids und der angrenzenden Halbleiteroberfläche verhindert wird. Durch den implantierten Stickstoff wird die Bildung der kapazitätsvermindernden Vogelschnäbel gehemmt, weil der Stickstoff als Oxidationshemmer im Material des Floating Gates wirkt. Gleichzeitig wird durch den Schutz des Tunneloxids und der angrenzenden Halbleiteroberfläche vor einer Nitridierung ein hohe Zuverlässigkeit der Feldeffekttransistorfunktionalität gewährleistet.

Nähere Einzelheiten des Mechanismus, der bei einem herkömmlichen Verfahren zur Vogelschnabelbildung führt, und Einzelheiten des erfindungsgemäßen Verfahrens, das diesen Mechanismus hemmt, werden nachstehend anhand von Zeichnungen erläutert:
Figuren 1 bis 5 sind Schnittansichten von Strukturen, die nacheinander bei einem herkömmlichen Verfahren entstehen;
Figuren 6 bis 12 veranschaulichen anhand von Schnittansichten gebildeter Strukturen eine Ausführungsform des erfindungsgemäßen Verfahrens;
Figuren 13 und 16 veranschaulichen anhand von Schnittansichten gebildeter Strukturen eine Abwandlung des in den Figuren 6-12 veranschaulichten Verfahrens;

Die in den Figuren gezeigten Strukturen sind annähernd maßstabsgerecht gezeichnet. Alle Figuren haben den gleichen Maßstab und zeigen Ansichten in jeweils der selben vertikalen Schnittebene, die so gelegt ist, dass sie durch die Gebiete von Source und Drain des zu bildenden Feldeffekttransistors geht.

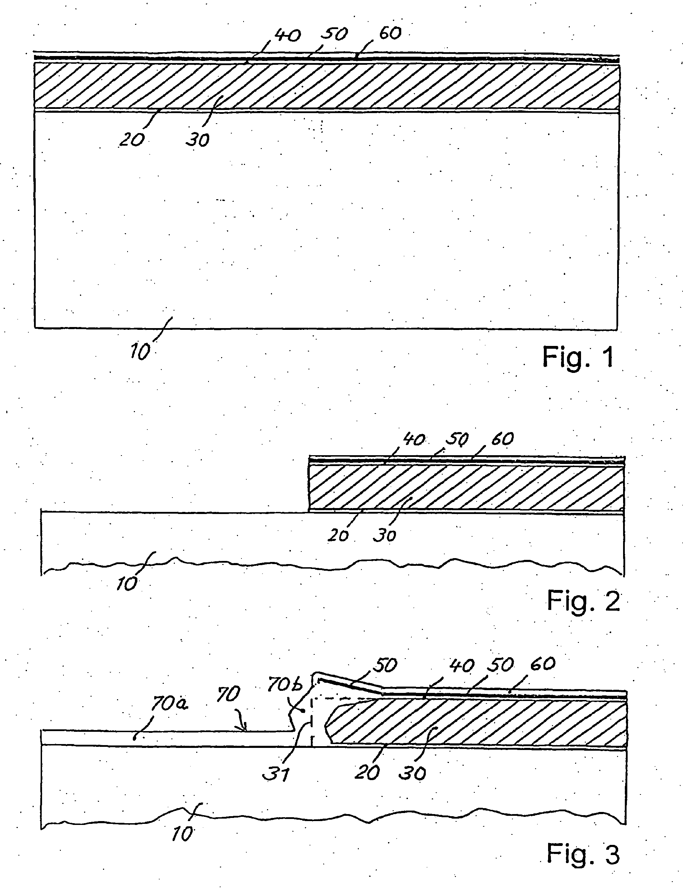

Bei einem herkömmlichen Verfahren wird gemäß der Fig. 1 auf einem Substrat 10, das z.B. aus p-dotiertem monokristallinem Silicium (Monosilicium) besteht, durch Oxidierung der Substratoberfläche eine sehr dünne erste Oxidschicht 20 (SiO₂ im genannten Beispielsfall) erzeugt. Diese Schicht 20 soll später das Tunneldielektrikum (Tunneloxid) für das Floating Gate bilden und wird z.B. auf Dicke von etwa 8 bis 10 nm dimensioniert. Über der Oxidschicht 20 wird eine wesentlich dickere Schicht 30 des Materials für das Floating Gate abgeschieden. Beim hier beschriebenen Beispiel handelt es sich um polykristallines Silicium (Polysilicium), das in situ mit n-Störstoff (z.B. Arsen oder Phosphor) dotiert wird. Anschließend wird auf der Oberfläche der Polysiliciumschicht 30 eine dünne sogenannte ONO-Schicht gebildet, d.h. eine kombinierte Oxid-Nitrid-Oxid-Schicht, bestehend aus einer unteren Oxidschicht 40 (SiO₂, etwa 5 nm), einer darüber liegenden Nitridschicht 50 (z.B. Siliciumnitrid Si₃N₄, etwa 5 nm) und einer oberen Oxidschicht 60 (SiO₂, etwa 5 nm). Diese ONO-Schicht 40-60 bildet ein hervorragendes Dielektrikum für die Koppelkapazität zwischen Steuergate und Floating Gate des herzustellenden Feldeffekttransistors

Anschließend erfolgt gemäß der Fig. 2 eine erste Strukturierung des aus den Schichten 20-60 bestehenden Aufbaus, so dass seine horizontale Ausdehnung auf die Linie begrenzt wird, die den später vom Steuergate überwölbten Umriß des Floating Gates beschreibt. Hierzu wird vorzugsweise die übliche Fotolithografie angewandt, um die zu entfernenden Bereiche des Schichtaufbaus selektiv bis zum Substrat, mindestens aber bis auf die Ebene der Tunneloxidschicht, wegzuätzen. Dies erfolgt wie allgemein üblich unter Verwendung einer aus Fotolack angefertigten Maskenschicht, die den stehenzulassenden Bereich des Schichtaufbaus 20-60 gegenüber dem Ätzmittel abschirmt und nach dem Ätzvorgang entfernt (gestrippt) wird.

Anschließend wird der gemäß Fig. 2 strukturierte Aufbau einer oxidierenden Atmosphäre ausgesetzt, um die geätzten Bereiche mit einer Oxidschicht 70 zu überziehen. Diese Oxidierung wird so gesteuert, dass die Oxidschicht 70 in ihrem Bereich 70a über dem Gebiet des Substrates 10 auf eine Dicke wächst, die der gewünschten Dicke (z.B. 30 nm) des "Hochvolt-Gateoxids" entspricht, d.h. der Isolierschicht zwischen Steuergate und Substrat des herzustellenden Feldeffekttransistors. Auch die bereits vorhandene Oxidschicht 60 über der Nitridschicht 50 wächst etwas an, allerdings weit weniger, weil das Nitrid schwer oxidierbar ist. Andererseits ist das Oxidwachstum im Bereich 70b an der Seitenflanke des Schichtaufbaus 20-60 äußerst stark, insbesondere wenn das dort freiliegende Material 30 des Floating Gate aus dotiertem Polysilicium besteht. Hierdurch wird das Material 30 an der Seitenflanke und an den benachbarten Kanten tiefgehend aufoxidiert, wie ein Vergleich mit der ursprünglichen Kontur zeigt, die durch eine gestrichelte Linie 31 in Fig. 3 eingezeichnet ist. Diese Aufoxidierung bildet insbesondere an der oberen Kante des Materials 30 sogenannte "Vogelschnäbel" aus Oxid, die sich keilförmig in den Bereich unter der Nitridschicht 50 erstrecken und diese Schicht mitsamt der oberen Oxidschicht 60 nach oben biegen.

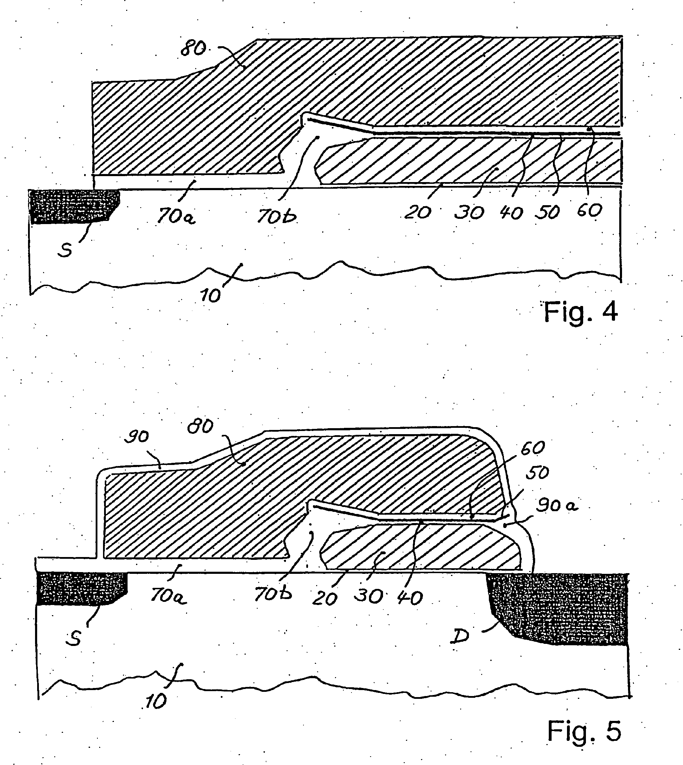

Aus dem in Fig. 3 gezeigten Aufbau wird dann der in Fig. 4 dargestellte Aufbau gebildet. Hierzu wird zunächst das Material 80 für das Steuergate abgeschieden, z.B. Polysilicium, das in situ mit n-Störstoff dotiert wird. Dann wird die Außenkontur des Materials 80, wo es die Seitenflanken des Floating Gates überwölbt, auf die gewünschte Umrißform des Steuergates begrenzt (also mit Ausnahme des rechten Randes, an dem später der Drain gebildet wird). Dies erfolgt wiederum durch fotolithografische Ätztechnik, wobei die aufgebrachte Fotolackmaske alle Bereiche mit Ausnahme des zu ätzenden Bereichs bedeckt und nach dem Ätzvorgang wieder gestrippt wird. An der freigeätzten Stelle des Substrates 10 wird durch Implantation von n-Störstoff (z.B. Arsen oder Phosphor) die Source S gebildet, unter Verwendung einer neuen Fotolackmaske, die alle Bereiche mit Ausnahme der Implantierungsstelle bedeckt und anschließend wieder gestrippt wird.

Der Aufbau nach Fig. 4 wird weiterbearbeitet, um zum Aufbau nach Fig. 5 zu gelangen. Im einzelnen wird unter Verwendung einer Fotolackmaske, die alle Bereiche mit Ausnahme des für den Drain vorgesehenen Bereichs abschirmt, der Schichtaufbau 20-80 in diesem Bereich (rechts in der Zeichnung) bis zum Substrat 10 weggeätzt. Nach dem Strippen des Lackes wird die Oberfläche der entstandenen Topographie oxidiert, um alles mit einer Oxidschicht 90 zu überziehen. Durch diese sogenannte "Post"-Oxidierung wird die Seitenflanke des Floating Gates besonders stark aufoxidiert, so dass auch dort im Bereich 90a ein "Vogelschnabel" aus Oxid entsteht, der die Nitridschicht 50 hochbiegen kann. Allerdings ist die Vogelschnabelbildung an dieser Stelle meist weniger ausgeprägt als im Oxidbereich 70b an den inneren Steuergate-Flanken, weil man die Post-Oxidierung (z.B. 20 nm SiO₂ auf dem Steuergate 80) meistens deutlich schwächer bemessen kann als die Dicke des Hochvolt-Gateoxids 70a (z.B. 30 nm SiO₂). Nach der Post-Oxidierung wird erneut eine Fotolackmaske gebildet, die alle Bereiche mit Ausnahme des für den Drain vorgesehenen Bereichs abschirmt. Unter Verwendung dieser Maske wird der n-Dotierstoff zur Bildung des Drains D implantiert.

Wie weiter oben erwähnt, führen die "Vogelschnäbel" an den Oxidbereichen 70b und 90a eines in der vorstehend beschriebenen Weise gebildeten Feldeffekttransistor dazu, dass sich die Koppelkapazität zwischen Steuergate 80 und Floating Gate 30 in unerwünschter Weise vermindert. Um dieses Problem zu vermeiden oder wenigstens zu lindern, wird in einem geeigneten Stadium des Herstellungsverfahrens Stickstoff in das Material des Floating Gates implantiert. Nachstehend werden zwei verschiedene Vorgehensweisen zur geeigneten Stickstoff-Implantation erläutert.

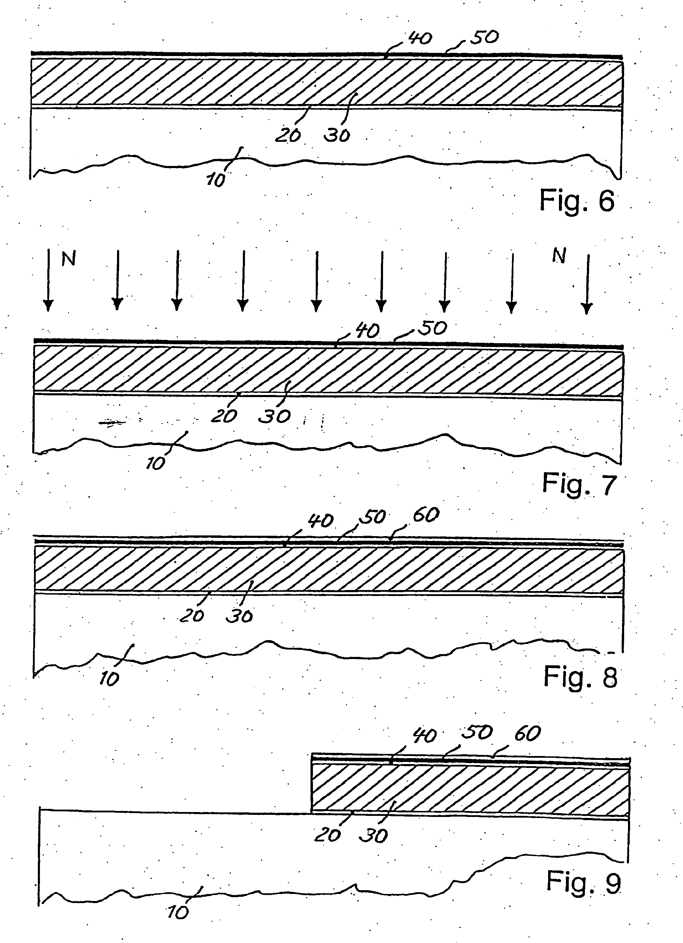

Bei einer ersten Ausführungsform wird gemäß der Fig. 6 auf dem Substrat 10 der gleiche Schichtaufbau hergestellt, wie er in Fig. 1 gezeigt ist, nur dass die Oxidierung der Nitridschicht 50 zur Bildung des oberen Oxids 60 der zu schaffenden ONO-Schicht vorerst unterbleibt. Dann erfolgt gemäß der Fig. 7 eine Implantierung von Stickstoff (N) senkrecht von oben in die Schicht 30 des Materials des Floating Gates, und zwar durch die dünne Nitridschicht 50 und die darunterliegende dünne Oxidschicht 40 hindurch.

Erst anschließend erfolgt die Oxidierung der Oberfläche der Nitridschicht 50 zur Bildung des oberen Oxids 60 und somit zur Fertigstellung der ONO-Schicht 40-60. Der so erhaltene Schichtaufbau ist in Fig. 8 dargestellt und entspricht jetzt demjenigen nach Fig. 1.

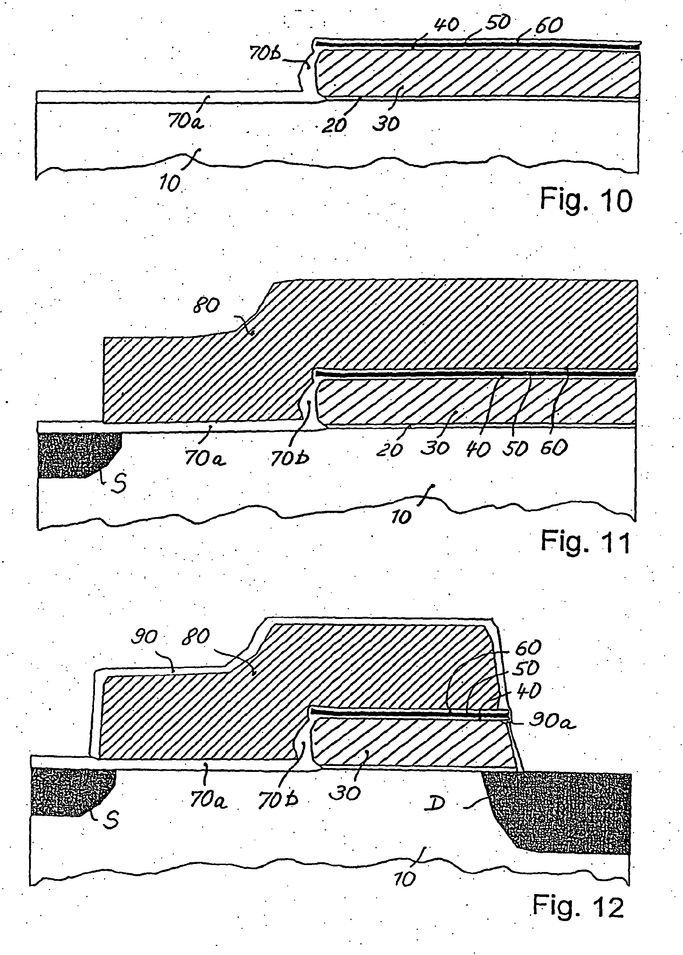

Dann folgen die gleichen Verfahrensschritte, wie sie oben anhand der Figuren 2 bis 5 beschrieben wurden: Es erfolgt eine erste fotolithografische Strukturierung zur Bildung der Struktur nach der Fig. 9, unter Durchführung der oben anhand der Fig. 2 beschriebenen Maßnahmen. Dann erfolgt, mittels der gleichen Verfahrensschritte, wie sie oben anhand der Fig. 3 beschrieben wurden, die Oxidierung zur Bildung des Hochvolt-Gateoxids 70a, wobei auch der Oxidbereich 70b an der Seitenflanke des Materials 30 des Floating Gates gebildet wird, wie in Fig. 10 dargestellt. Ein Vergleich mit der Fig. 3 zeigt, dass wegen der oxidationshemmenden Wirkung des im Material 30 implantierten Stickstoffes die Aufoxidierung im Bereich 70b deutlich schwächer ist. Insbesondere in der Nähe der oberen Kante des Materials 30, wo die Konzentration des von oben implantierten Stickstoffes am höchsten ist, ergibt sich eine weit geringere Aufoxidierung als im Falle der Fig. 3. Es entstehen demnach keine (oder nur sehr schwache) "Vogelschnäbel", und die Nitridschicht 50 wird nicht (oder nur sehr wenig) nach oben gebogen. Die Nitridschicht 50 selbst wird wegen des auch dort implantierten Stickstoffs praktisch überhaupt nicht weiter aufoxidiert, so dass die Schicht 60 nicht auf Kosten der Nitridschicht 50 dicker wird.

Anschließend folgen das Abscheiden der Schicht 80 für das Gateoxid, das Strukturieren dieser Schicht zum Freilegen des für die Source vorgesehenen Substratbereiches und das Implantieren der Source S gemäß der Fig. 10, wobei die gleichen Verfahrensschritte angewendet werden, wie sie oben anhand der Fig. 4 beschrieben wurden. Dann erfolgt die erneute Strukturierung zur Offenlegung des für den Drain vorgesehenen Bereichs, die Bildung der Post-Oxidschicht 90 und das Implantieren des Drains gemäß der Fig. 11, wobei die gleichen Verfahrensschritte angewendet werden, wie sie oben anhand der Fig. 5 beschrieben wurden. Ein Vergleich der Fig. 11 mit der Fig. 5 zeigt, dass im Falle der Fig. 11 die Vogelschnabelbildung auch im Post-Oxid 90 im Bereich 90a an der drainseitigen Flanke des Floating Gates 30 infolge der Stickstoffimplantation deutlich schwächer ist als im Falle der Fig. 5.

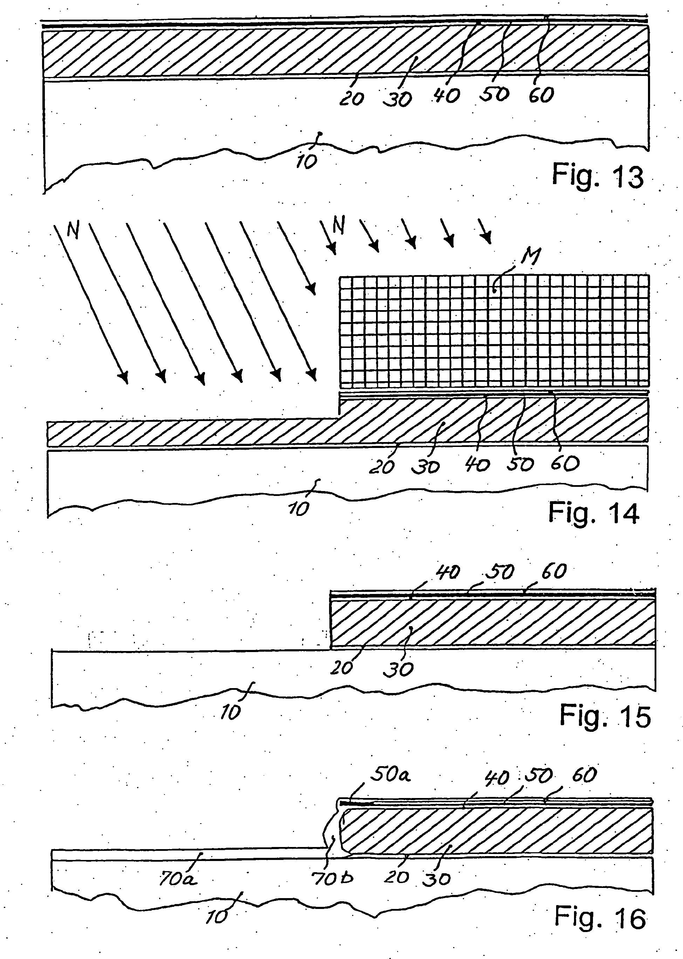

Bei einer zweiten Ausführungsform wird gemäß der Fig. 13 auf dem Substrat 10 der gleiche Schichtaufbau hergestellt, wie er in Fig. 1 gezeigt ist, also inklusive des oberen Oxids 60 der vorzusehenden ONO-Schicht. Anschließend wird mit der Strukturierung des aus den Schichten 20-60 bestehenden Aufbaus begonnen, unter Anwendung des fotolithografischen Ätzverfahrens mit einer Maske M, wie es oben anhand der Fig. 2 beschrieben wurde. Gemäß der Fig. 14, in der auch die Fotolackmaske 14 gezeigt ist, wird das Ätzen jedoch vor dem Erreichen der endgültigen Ätztiefe unterbrochen, vorzugsweise beim Erreichen etwa der halben Tiefe. In diesem Stadium wird Stickstoff schräg von oben in die teilweise freigelegte Seitenflanke des Materials 30 des Floating Gate implantiert, wobei die Oberseite des vom Ätzen ausgenommenen Bereichs des Schichtaufbaus durch die Fotolackmaske M abgeschirmt wird.

Anschließend wird das Ätzen bis auf die endgültige Tiefe fortgesetzt. Die hiermit erhaltene Struktur ist in Fig. 15 gezeigt und entspricht derjenigen nach Fig. 9. Ausgehend hiervon erfolgt die Oxidierung zur Bildung des Hochvolt-Gateoxids im Bereich 70a und des Seitenflanken-Oxids im Bereich 70b. Hierdurch ergibt sich der in Fig. 16 dargestellte Aufbau, der demjenigen nach Fig. 10 gleicht, mit ähnlich geringer Vogelschnabelbildung im Bereich 70b des der Oxidschicht 70. Allerdings ist im Falle der Fig. 16 die Nitridschicht 50 nur in einem Bereich 50a in der Nähe ihres Randes an der Seitenflanke auf ihrer ursprünglichen Dicke geblieben, weil nur dort der aus schräger Richtung implantierte Stickstoff in die Nitridschicht 50 eingedrungen ist und seine oxidationshemmende Wirkung entfaltet. Im restlichen Bereich der Nitridschicht 50 wurde wegen der abschirmenden Maske M (Fig. 14) kaum Stickstoff implantiert, so dass dort eine geringfügige Aufoxidierung des Nitrids erfolgt ist und die Nitridschicht 50 in diesem Bereich etwas dünner geworden ist, wie in Fig. 16 gezeigt.

Anschließend erfolgt die gleiche Weiterbehandlung, wie sie oben anhand der Figuren 4 und 5 beschrieben wurde. Dabei ergeben sich nacheinander die gleichen Strukturen, wie sie in den Figuren 11 und 12 gezeigt sind. Im Bereich 90a des Postoxids 90 (Fig. 12) ist die Vogelschnabelbildung allerdings weniger reduziert, weil das Material 30 des Floating Gate an dieser Stelle infolge der abschirmenden Maske M (Fig. 14) weniger Stickstoffimplantat empfangen hat.

Die vorstehend beschriebenen Ausführungsformen sind nur als Beispiele zu verstehen. Die Erfindung ist nicht beschränkt auf die beschriebenen Schrittfolgen. Die Stickstoff-Implantierung kann erfolgreich als Zusatzschritt bei jedem beliebigen Herstellungsverfahren für Feldeffekttransistoren mit Floating Gate angewendet werden, bei welchem eine Oxidierung von Seitenflanken des

Floating Gates erfolgt. Bedingung ist nur dass die Stickstoff-Implantierung irgendwann vor dieser Oxidierung und in einer Menge erfolgt, welche die Oxidierung der betreffenden Seitenflanke merklich mindert.

## Patentansprüche

1. Verfahren zur Herstellung eines Feldeffekttransistors mit einem Floating Gate, wobei folgende Schritte durchgeführt werden:
A) auf einem Teil der Oberfläche eines Halbleitersubstrates (10) wird ein erster Schichtaufbau (20-60) gebildet, der als unterste Schicht ein Tunneldielektrikum (20) für das Floating Gate, darüber eine Schicht (30) aus dem Material des Floating Gates und als oberste Schicht ein Koppeldielektrikum (40-60) mit einer Nitridschicht (50) enthält und strukturiert ist zur Bildung von Seitenflanken, die Teile des Umrisses des Floating Gates definieren;
B) durch Einwirken einer oxidierenden Atmosphäre werden ein übriger Teil des Substratoberfläche und die Seitenflanken des ersten Schichtaufbaus mit einer Oxidschicht (70) überzogen, wobei zu einem Zeitpunkt vor dem Einwirken der oxidierenden Atmosphäre Stickstoff in das Material (30) des Floating Gates in einer Menge implantiert wird, welche die Oxidierung an dessen Seitenflanken merklich mindert; und
C) anschließend wird das Material (80) des Steuergates aufgebracht, und nach Strukturierung der Geometrie des so gebildeten gesamten Schichtaufbaus (20-80) auf einen gewünschten Umriß erfolgt eine Post-Oxidierung (90) der Oberflächen einschließlich der Flanken dieses Schichtaufbaus,
**dadurch gekennzeichnet, dass** der Stickstoff nach dem Aufbringen der Nitridschicht (50) des Koppeldielektrikums (40-60) und vor dem Strukturieren der Seitenflanken des ersten Schichtaufbaus (20-60) durch die Nitridschicht (50) hindurch in das Material (30) des Floating Gates implantiert wird.

2. Verfahren nach Anspruch 1, **dadurch gekennzeichnet, dass** zur Herstellung des Koppeldielektrikums (40-60) auf der Oberseite der aus dem Material (30) des Floating Gates bestehenden Schicht zunächst eine untere Oxidschicht (40), dann die Nitridschicht (50) und anschließend eine obere Oxidschicht (60) gebildet werden.

3. Verfahren nach den Anspruch 2, **dadurch gekennzeichnet, dass** die Stickstoff-Implantierung vor dem Aufbringen der oberen Oxidschicht (60) erfolgt.

4. Verfahren zur Herstellung eines Feldeffekttransistors mit einem Floating Gate, wobei folgende Schritte durchgeführt werden:
A) auf einem Teil der Oberfläche eines Halbleitersubstrates (10) wird ein erster Schichtaufbau (20-60) gebildet, der als unterste Schicht ein Tunneldielektrikum (20) für das Floating Gate, darüber eine Schicht (30) aus dem Material des Floating Gates und als oberste Schicht ein Koppeldielektrikum (40-60) mit einer Nitridschicht (50) enthält und strukturiert ist zur Bildung von Seitenflanken, die Teile des Umrisses des Floating Gates definieren;
B) durch Einwirken einer oxidierenden Atmosphäre werden ein übriger Teil des Substratoberfläche und die Seitenflanken des ersten Schichtaufbaus mit einer Oxidschicht (70) überzogen, wobei zu einem Zeitpunkt vor dem Einwirken der oxidierenden Atmosphäre Stickstoff in das Material (30) des Floating Gates in einer Menge implantiert wird, welche die Oxidierung an dessen Seitenflanken merklich mindert; und
C) anschließend wird das Material (80) des Steuergates aufgebracht, und nach Strukturierung der Geometrie des so gebildeten gesamten Schichtaufbaus (20-80) auf einen gewünschten Umriß erfolgt eine Post-Oxidierung (90) der Oberflächen einschließlich der Flanken dieses Schichtaufbaus,
**dadurch gekennzeichnet, dass** die Strukturierung der Seitenflanken des ersten Schichtaufbaus (20-60) durch selektives Ätzen auf eine endgültige Tiefe erfolgt, die mindestens bis zum unteren Ende des Materials (30) des Floating Gates reicht, wobei der Stickstoff in die durch diesen Ätzprozess freigelegte Seitenflanke des Materials (30) des Floating Gates nach einem ersten Teilabschnitt des Ätzprozesses implantiert wird, vorzugsweise dann, wenn ungefähr die Hälfte der endgültigen Ätztiefe erreicht ist.

5. Verfahren nach Anspruch 4, **dadurch gekennzeichnet, dass** während der Stickstoff-Implantierung der von der selektiven Ätzung ausgesparte Bereich des ersten Schichtaufbaus (20-60) durch eine Maske (M) abgeschirmt wird.

6. Verfahren nach Anspruch 4 oder 5, **dadurch gekennzeichnet, dass** die Stickstoff-Implantierung schräg zu den Ebenen der Schichten und der Seitenflanke des ersten Schichtaufbaus (20-60) erfolgt.

7. Verfahren nach einem der Ansprüche 1 bis 6, **dadurch gekennzeichnet, dass** das Tunneldielektrikum (20) für das Floating Gate gebildet wird durch Oxidierung der Substratoberfläche vor dem Aufbringen des Materials (30) des Floating Gates.

8. Verfahren nach einem der Ansprüche 1 bis 7, **dadurch gekennzeichnet, dass** der Schritt C folgende Teilschritte enthält:
C1) Strukturierung des sourceseitigen Endes des Gesamt-Schichtaufbaus (20-80) durch selektives Ätzen;
C2) Implantierung der Source-Dotierung;
C3) Strukturierung des drainseitigen Endes des Gesamt-Schichtaufbaus (20-80) durch selektives Ätzen;
C4) Post-Oxidierung (90) der durch die Schritte C1 und C3 freigelegten Oberflächen des Substrates (10) und aller Oberflächen einschließlich der Flanken des strukturierten Gesamt-Schichtaufbaus (20-80);
C5) Entfernen des Post-Oxids (90) an der Substratoberfläche im Bereich des zu bildenden Drains (D) und Implantierung der Drain-Dotierung in diesem Bereich.

9. Verfahren nach einem der vorhergehenden Ansprüche, **dadurch gekennzeichnet, dass** für das Substrat (10) monokristallines Silicium verwendet wird.

10. Verfahren nach einem der vorhergehenden Ansprüche, **dadurch gekennzeichnet, dass** für das Floating Gate (30) und das Steuergate (80) dotiertes polykristallines Silicium verwendet wird.

11. Verfahren nach einem der vorhergehenden Ansprüche, **dadurch gekennzeichnet, dass** die Nitridschicht (50) aus Siliciumnitrid gebildet wird.

## Claims

1. Method for fabricating a field-effect transistor having a floating gate, the following steps being carried out:
A) a first layer construction (20-60) is formed on a part of the surface of a semiconductor substrate (10), which layer construction contains, as bottommost layer, a tunnel dielectric (20) for the floating gate, above that a layer (30) made of the material of the floating gate and, as topmost layer, a coupling dielectric (40-60) with a nitride layer (50) and is patterned in order to form sidewalls which define parts of the contour of the floating gate;
B) through the action of an oxidizing atmosphere, a remaining part of the substrate surface and the sidewalls of the first layer construction are coated with an oxide layer (70), in which case, at a point in time prior to the action of the oxidizing atmosphere, nitrogen is implanted into the material (30) of the floating gate in a quantity which appreciably reduces the oxidation at the sidewalls thereof; and
C) afterward, the material (80) of the control gate is applied, and, after the patterning of the geometry of the entire layer construction (20-80) thus formed to a desired contour, a post-oxidation (90) of the surfaces including the sidewalls of said layer construction takes place,
**characterized in that**
after the application of the nitride layer (50) of the coupling dielectric (40-60) and before the patterning of the sidewalls of the first layer construction (20-60), the nitrogen is implanted through the nitride layer (50) into the material (30) of the floating gate.

2. Method according to Claim 1, **characterized in that**, in order to fabricate the coupling dielectric (40-60), on the top side of the layer composed of the material (30) of the floating gate, there are formed firstly a lower oxide layer (50), then the nitride layer (50) and subsequently an upper oxide layer (60).

3. Method according to Claim 2, **characterized in that** the nitrogen implantation is effected before the application of the upper oxide layer (60).

4. Method for fabricating a field-effect transistor having a floating gate, the following steps being carried out:
A) a first layer construction (20-60) is formed on a part of the surface of a semiconductor substrate (10), which layer construction contains, as bottommost layer, a tunnel dielectric (20) for the floating gate, above that a layer (30) made of the material of the floating gate and, as topmost layer, a coupling dielectric (40-60) with a nitride layer (50) and is patterned in order to form sidewalls which define parts of the contour of the floating gate;
B) through the action of an oxidizing atmosphere, a remaining part of the substrate surface and the sidewalls of the first layer construction are coated with an oxide layer (70), in which case, at a point in time prior to the action of the oxidizing atmosphere, nitrogen is implanted into the material (30) of the floating gate in a quantity which appreciably reduces the oxidation at the sidewalls thereof; and
C) afterward, the material (80) of the control gate is applied, and, after the patterning of the geometry of the entire layer construction (20-80) thus formed to a desired contour, a post-oxidation (90) of the surfaces including the sidewalls of said layer construction takes place,
**characterized in that**
the sidewalls of the first layer construction (20-60) are patterned by selective etching to a final depth which reaches at least as far as the lower end of the material (30) of the floating gate, the nitrogen being implanted after a first subsection of the etching process into the sidewall of the material (30) of the floating gate that is uncovered by this etching process, preferably when approximately half of the final depth has been reached.

5. Method according to Claim 4, **characterized in that**, during the nitrogen implantation, that region of the first layer construction (20-60) that was omitted from the selective etching is shielded by a mask (M).

6. Method according to Claims 4 or 5, **characterized in that** the nitrogen implantation is effected obliquely with respect to the planes of the layers and the sidewall of the first layer construction (20-60).

7. Method according to Claim 6, **characterized in that** the tunnel dielectric (20) for the floating gate is formed by oxidation of the substrate surface before the application of the material (30) of the floating gate.

8. Method according to one of Claims 1 to 7, **characterized in that** step C contains the following substeps:
C1) patterning of the source end of the overall layer construction (20-80) by selective etching;
C2) implantation of the source doping;
C3) patterning of the drain end of the overall layer construction (20-80) by selective etching;
C4) post-oxidation (90) of the surfaces of the substrate (10) uncovered by steps C1 and C3 and of all the surfaces including the sidewalls of the patterned overall layer construction (20-80);
C5) removal of the post-oxide (90) at the substrate surface in the region of the drain (D) to be formed and implantation of the drain doping in this region.

9. Method according to one of the preceding claims, **characterized in that** monocrystalline silicon is used for the substrate (10).

10. Method according to one of the preceding claims, **characterized in that** doped polycrystalline silicon is used for the floating gate (30) and the control gate (80).

11. Method according to one of the preceding claims, **characterized in that** the nitride layer (30) is formed from silicon nitride.

## Revendications

1. Procédé de fabrication d'un transistor à effet de champ à grille flottante, qui comprend les étapes consistant à :
A) former sur une partie de la surface d'un substrat semi-conducteur (10) une première structure stratifiée (20-60) qui contient comme couche inférieure un diélectrique tunnel (20) pour la grille flottante et qui est surmontée par une couche (30) du matériau de la grille flottante, et comme couche supérieure un diélectrique de couplage (40-60) à couche (50) de nitrure, la structure stratifiée étant structurée de manière à former des flancs latéraux qui définissent des parties du périmètre de la grille flottante,
B) par action d'une atmosphère oxydante, recouvrir le reste de la surface du substrat et les flancs latéraux de la première structure stratifiée d'une couche d'oxyde (70), et avant l'action de l'atmosphère oxydante, implanter de l'azote dans le matériau (30) de la grille flottante en une quantité qui diminue notablement l'oxydation de ses flancs latéraux et
C) appliquer ensuite le matériau (80) de la grille de commande, et après structuration de l'ensemble de la structure stratifiée (20-80) ainsi formée, post-oxyder (90) la surface ainsi que des flancs de cette structure stratifiée sur un périmètre souhaité,
**caractérisé en ce que**
après l'application de la couche de nitrure (50) du diélectrique du couplage (40-60) et avant la structuration des flancs latéraux de la première structure stratifiée (20-60) à travers la couche de nitrure (50), implanter de l'azote dans le matériau (30) de la grille flottante.

2. Procédé selon la revendication 1, **caractérisé en ce que** pour réaliser le diélectrique de couplage (40-60), une couche inférieure d'oxyde (40) est d'abord formée sur le côté supérieur de la couche constituée du matériau (30) de la grille flottante, avec ensuite la formation d'une couche de nitrure (50) et ensuite d'une couche supérieure d'oxyde (60).

3. Procédé selon la revendication 2, **caractérisé en ce que** l'implantation d'azote a lieu avant l'application de la couche supérieure d'oxyde (60).

4. Procédé de fabrication d'un transistor à effet de champ à grille flottante, qui comprend les étapes suivantes :
A) former sur une partie de la surface d'un substrat semi-conducteur (10) une première structure stratifiée (20-60) qui contient comme couche inférieure un diélectrique tunnel (20) pour la grille flottante et qui est surmontée par une couche (30) du matériau de la grille flottante, et comme couche supérieure un diélectrique de couplage (40-60) à couche de nitrure (50), la structure stratifiée étant structurée de manière à former des flancs latéraux qui définissent des parties du périmètre de la grille flottante,
B) par action d'une atmosphère oxydante, recouvrir le reste de la surface du substrat et les flancs latéraux de la première structure stratifiée d'une couche d'oxyde (70), et avant l'action de l'atmosphère oxydante, implanter de l'azote dans le matériau (30) de la grille flottante en une quantité qui diminue notablement l'oxydation de ses flancs latéraux et
C) appliquer ensuite le matériau (80) de la grille de commande, et après structuration de l'ensemble de la structure stratifiée (20-80) ainsi formée, post-oxyder (90) la surface ainsi que des flancs de cette structure stratifiée sur un périmètre souhaité,
**caractérisé en ce que**
la structuration des flancs latéraux de la première structure stratifiée (20-60) s'effectue par gravure sélective à une profondeur finale qui s'étend au moins jusqu'à l'extrémité inférieure du matériau (30) de la grille flottante et
**en ce que** l'azote est implanté dans les flancs latéraux du matériau (30) de la grille flottante libéré par cette opération de gravure après une première partie de l'opération de gravure, de préférence lorsque environ la moitié de la profondeur finale de gravure a été atteinte.

5. Procédé selon la revendication 4, **caractérisé en ce que** pendant l'implantation d'azote, la partie de la première structure stratifiée (20-60) épargnée par la gravure sélective est protégée par un masque (M).

6. Procédé selon les revendications 4 ou 5, **caractérisé en ce que** l'implantation d'azote s'effectue obliquement par rapport au plan des couches et des flancs latéraux de la première structure stratifiée (20-60).

7. Procédé selon l'une des revendications 1 à 6, **caractérisé en ce que** le diélectrique tunnel (20) prévu pour la grille flottante est formé par oxydation de la surface du substrat avant l'application du matériau (30) de la grille flottante.

8. Procédé selon l'une des revendications 1 à 7, **caractérisé en ce que** l'étape C) comprend les étapes partielles qui consistent à :
C1) structurer l'extrémité côté source de la structure stratifiée globale (20-80) par gravure sélective,
C2) implanter le dopage de la source,
C3) structurer l'extrémité côté drain de la structure stratifiée globale (20-80) par gravure sélective,
C4) post-oxyder (90) les surfaces du substrat (10) libérées par les étapes C1 et C3 et toutes les surfaces, notamment des flancs de la structure stratifiée globale (20-80) structurée, et
C5) enlever le post-oxyde (90) de la surface du substrat dans la zone du drain (D) à former et implanter le dopage de drain dans cette partie.

9. Procédé selon l'une des revendications précédentes, **caractérisé en ce qu'**il utilise du silicium monocristallin pour le substrat (10).

10. Procédé selon l'une des revendications précédentes, **caractérisé en ce qu'**il utilise du silicium polycristallin dopé pour la grille flottante (30) et la grille de commande (80).

11. Procédé selon l'une des revendications précédentes, **caractérisé en ce que** la couche de nitrure (50) est constituée de nitrure de silicium.
